# FASCICULE DE BREVET EUROPEEN

(11) **EP 3 864 422 B1**
(45) Date de publication et mention de la délivrance du brevet: **03.04.2024**
(21) Numéro de dépôt: 19871912.2
(22) Date de dépôt: 04.10.2019
(51) Int. Cl.: G01R 31/08, G01R 29/16, H02J 13/00, G01R 22/06, G01R 21/133

(54) **MÉTHODE, SYSTÈME ET PRODUIT LOGICIEL PERMETTANT D'IDENTIFIER DES INSTALLATIONS SUSCEPTIBLES DE PRÉSENTER UNE NON-CONFORMITÉ ÉLECTRIQUE**
VERFAHREN, SYSTEM UND SOFTWAREPRODUKT ZUR IDENTIFIZIERUNG VON GERÄTEN, DIE EINE ELEKTRISCHE NICHTKONFORMITÄT AUFWEISEN KÖNNEN
METHOD, SYSTEM AND SOFTWARE PRODUCT FOR IDENTIFYING EQUIPMENT THAT CAN PRESENT AN ELECTRICAL NON-CONFORMITY

(30) Priorité: 11.10.2018 CA 3020432
(43) Date de publication de la demande: 18.08.2021
(73) Titulaire: Hydro-Québec, Montréal QC H2Z 1A4 (CA)
(72) Inventeur: CARIGNAN, Jean, Trois-Rivières, Québec G8Y 7J7 (CA); GELINAS, Sylvain, Québec G0X 2N0 (CA); POULIN, Alain, Québec G9P 5A8 (CA)
(74) Mandataire: Lavoix
(86) Numéro de dépôt international: PCT/CA2019/051425
(87) Numéro de publication internationale: WO 2020/073117

(56) Documents cités:
- WO-A1-2017/100916
- WO-A1-2018/010028
- CA-A1- 2 936 212
- US-A1- 2009 045 976
- US-A1- 2011 301 894
- US-A1- 2012 123 995
- US-A1- 2015 323 344

## Description

### DOMAINE DE L'INVENTION

L'invention porte sur un système et une méthode de détection des installations électriques susceptibles de présenter une non-conformité électrique (NCE), via l'application de traitements algorithmiques sur des profils électriques produits par des compteurs nouvelle génération (CNG).

### CONTEXTE

La plupart des utilités électriques ont procédé ou procèdent au remplacement de compteurs électromécaniques par des CNG. Ces compteurs transmettent automatiquement les paramètres mesurés vers un système central d'acquisition de données, à intervalle de temps régulier.

Le déploiement à grande échelle des CNG rend désormais disponibles d'importantes quantités d'informations relatives aux différentes charges (installations électriques des clients) raccordées au réseau de distribution électrique (énergie, tension, courants, etc.). Ces informations ouvrent un éventail de nouvelles opportunités entre autres au niveau de la conduite et la planification du réseau, de la connaissance des clients et l'identification de NCE sur le réseau.

Avec le déploiement à grande échelle des CNG, la relève des compteurs est maintenant effectuée à distance et de façon automatisée. Ainsi, la présence sur le terrain de releveurs de compteurs est de plus en plus rare. Ce nouveau mode d'opération prive les gestionnaires de réseaux d'une source importante de signalement de NCE potentielles.

Cette situation est à la base du nouveau besoin d'identifier automatiquement les installations électriques susceptibles de présenter une NCE.

### SOMMAIRE

Selon un premier aspect de l'invention, une méthode est proposée, pour identifier de façon automatique des installations électriques susceptibles de présenter une NCE sur un réseau de distribution électrique, tel que définie dans la revendication 1.

Avantageusement, la méthode développée ne requiert que les profils électriques récupérés des compteurs et les outils informatiques pour identifier les installations électriques susceptibles d'être non conformes, sans recours à aucun autre équipement de sous mesurage.

Sans s'y limiter, la méthode peut comprendre une étape de récupérer des données nominatives caractérisant les installations électriques, et une étape permettant de confirmer ou d'infirmer que les installations électriques identifiées sont bien susceptibles de présenter une NCE, en croisant lesdites informations nominatives et les indicateurs de NCE ayant rencontré leurs conditions de ciblage.

Les données nominatives peuvent comprendre au moins une des informations suivantes, pour chacune des installations électriques : la nature de l'installation électrique, soit monophasée ou polyphasée; le tarif auquel est assujettie l'installation électrique; la vocation du ou des bâtiment(s) associé(s) à l'installation électrique (résidentielle, commerciale, institutionnelle ou industrielle); et la source principale d'énergie utilisée pour chauffer le ou les bâtiments.

La méthode peut aussi inclure une étape de sélectionner la totalité ou une partie des indicateurs de NCE à appliquer aux profils, et ce, en fonction des informations contenues dans les données nominatives.

La méthode peut également prévoir la récupération de données météorologiques, et de confirmer ou d'infirmer que les installations électriques identifiées sont bien susceptibles de présenter une NCE, en croisant lesdites données météorologiques et les indicateurs de NCE ayant rencontré leurs conditions de ciblages. Les données météorologiques peuvent comprendre, à titre d'exemple, la température extérieure locale, la date et l'heure déterminées au moment où les profils électriques ont été générés.

La méthode comprend préférablement une étape d'identifier la nature des installations électriques, soit monophasées ou polyphasées, basé sur les profils récupérés et/ou sur les informations nominatives. Les profils électriques provenant des installations monophasées et biphasées comprennent au moins des profils de tension (en V) et d'énergie active (en kWh). Pour les installations électriques polyphasées, les profils récupérés comprennent l'énergie active (en kWh) totale et par phase électrique (φ_{A}, φ_{B}, φ_{C}), une mesure d'énergie apparente (en kVAh) totale et par phase électrique, une mesure d'énergie réactive (kVARh) totale et par phase électrique, une mesure des tensions (en V) par phase et une mesure des courants (en A) par phase.

La validation d'une NCE s'effectue en fonction de l'existence d'indicateurs ayant rencontré leur condition de ciblage et de leurs valeurs. Pour certains types d'indicateurs, lorsque le degré de certitude est grand (probabilité de 1 00% par exemple), il est possible d'interrompre automatiquement l'approvisionnement en électricité d'une installation donnée, le degré de certitude étant lié au nombre, à l'occurrence et au type d'indicateurs de NCE ayant rencontré les conditions de ciblage.

Une partie des indicateurs de NCE peuvent être des indicateurs autonomes et d'autres indicateurs peuvent être des indicateurs relationnels. Un indicateur de NCE est considéré comme autonome si son traitement algorithmique ne fait intervenir que les données provenant des profils de l'installation analysée. Pour leur part, les indicateurs relationnels font intervenir les profils des installations voisines, c.-à-d. qui sont reliées à un même transformateur de distribution, à une même phase électrique, à une même ligne électrique ou à un même poste de distribution.

Préférablement, certains des traitements algorithmiques sont associés à une première classe d'indicateurs NCE appelée indicateurs d'états. Selon la méthode, on peut calculer un ou plusieurs des indicateurs d'états, incluant un taux de captation de données énergétiques; un taux de captation des données de tension; un débalancement en tension; un débalancement en courant; et le rapport de l'énergie apparente et active. Les outils informatiques valident ainsi, à partir des données indicatives d'états calculées, une probabilité que les installations électriques identifiées soient des installations non conformes.

Une partie des traitements algorithmiques peut être associée à une seconde classe d'indicateurs NCE appelée indicateurs de positionnement. En ce cas, les outils informatiques déterminent, avec les indicateurs de positionnement calculés, si une installation électrique donnée est située sur la ligne électrique analysée, mais est reliée à un autre transformateur que celui défini dans les données nominatives; ou si une installation donnée n'est pas raccordée à la ligne analysée. Les outils informatiques valident ainsi, à partir des données indicatives de positionnement calculées, une probabilité que les installations électriques identifiées soient des installations non conformes.

Une partie des traitements algorithmiques peut aussi être associée à une troisième classe d'indicateurs de NCE, soit des indicateurs de pertes non techniques. Différents traitements algorithmiques sont associés à des sous-classes de la classe des indicateurs de pertes non techniques. Ainsi, des traitements algorithmiques sont associés à une première sous-classe d'indicateurs de pertes non techniques, pour lesquels un ou des indicateur(s) de manipulation de compteur ou de compteur défectueux sont calculés, incluant des indicateurs d'altération du bobinage de tension; de données identiques en énergie; de données identiques en tension; de résistance en série sur un transformateur de courant; et de courant triphasé nul avec consommation non nulle. Les outils informatiques valident ainsi, à partir des données indicatives de pertes non techniques calculées, une probabilité que les installations électriques identifiées soient des installations non conformes. Par exemple, l'indicateur « d'altération du bobinage de tension » permet d'identifier les compteurs ayant un bobinage modifié.

Une autre partie des traitements algorithmiques peut être associée à une seconde sous-classe d'indicateurs de pertes non techniques, pour lesquels un ou des indicateur(s) d'anomalies par comparaison sont calculés, incluant par exemple : un indicateur de consommation nocturne; un indicateur d'écart de tension des valeurs moyennes monophasées; un indicateur d'écart de tension des valeurs moyennes interphases; un indicateur d'écart de tension des valeurs moyennes inter-clients; un indicateur d'écarts de tension des valeurs moyennes sous un transformateur polyphasées; un indicateur du niveau de tension à consommation nulle; un indicateur du ratio de courant; ou un indicateur de perte et de retour de tension non synchronisés. Les outils informatiques valident ainsi, à partir des données indicatives d'anomalies par comparaison, une probabilité que les installations électriques identifiées soient des installations non conformes.

Une autre partie des traitements algorithmiques peut être associée à une troisième sous-classe d'indicateurs de pertes non techniques, pour lesquels un ou des indicateur(s) de raccords de compteur ou de composantes inadéquats sont calculés, incluant par exemple un indicateur d'absence de courant; un indicateur d'absence de tension; un indicateur de données en énergie négatives; ou un indicateur de tension nulle avec courant. Les outils informatiques valident ainsi, à partir des données indicatives de raccords de compteur ou de composantes inadéquats, une probabilité que les installations électriques identifiées soient des installations non conformes.

Une autre partie des traitements algorithmiques peut être associée à une quatrième sous-classe d'indicateurs de pertes non techniques, pour lesquels un indicateur d'aberrations transitoires est calculé, en identifiant de grands écarts de tensions sur les profils analysés. Les outils informatiques valident ainsi, à partir des données indicatives d'aberrations transitoires, une probabilité que les installations électriques identifiées soient des installations non conformes.

Une autre partie des traitements algorithmiques peut être associée à une cinquième sous-classe d'indicateurs de pertes non techniques, pour lesquels un ou des indicateur(s) de mode d'opération hors norme sont calculés, incluant par exemple un indicateur de chauffage biénergie; un indicateur de puissance de pointe hors norme; un indicateur de tension moyenne hors norme; une indication d'un transformateur à raccordement unique; un facteur de détermination disparate; une validation de l'énergie active consommée; une tension hors norme avec courant. Les outils informatiques valident ainsi, à partir des données indicatives de mode d'opération hors norme, une probabilité que les installations électriques identifiées soient des installations non conformes.

Enfin, une autre partie des traitements algorithmiques peut être associée à une sixième sous-classe d'indicateurs de pertes non techniques, pour lesquels un ou des indicateur(s) de charges électriques cycliques non conformes sont calculés, incluant par exemple l'application d'une transformation de Fourrier sur les données de profils et un indicateur de tension cyclique sans appel de puissance. Les outils informatiques valident ainsi, à partir des données indicatives de charges cycliques non conformes, une probabilité que les installations électriques identifiées soient des installations non conformes.

La méthode comprend préférablement une étape de générer une structure de résultats comprenant les données indicatives des différents types de NCE potentielles identifiées pour chaque installation électrique et une étape de générer des graphiques représentant visuellement les NCE potentielles identifiées. Il est également possible de générer, via une application logicielle, des demandes d'inspection des installations électriques identifiées comme étant susceptibles de présenter une NCE. Les outils informatiques peuvent aussi attribuer une priorité aux installations électriques identifiées comme susceptibles de présenter une NCE, en fonction d'un degré de certitude quant à l'existence de NCE pour une installation donnée, le degré de certitude étant lié au nombre, à l'occurrence et au type d'indicateurs de NCE ayant rencontré les conditions de ciblage.

La méthode automatique développée est particulièrement efficace lorsque les mesures des profils électriques des compteurs sont prises au moins une fois l'heure.

Dans un mode de réalisation optionnel, la méthode comprend une étape d'interruption automatique de l'approvisionnement en électricité pour au moins certaines des installations électriques identifiées, par exemple par l'envoi d'une requête d'ouverture d'un élément de commande situé dans le compteur lié à l'installation électrique identifiée comme étant non conforme.

Selon un autre aspect de l'invention, un système pour identifier de façon automatique les installations électriques étant susceptibles de présenter une NCE sur un réseau de distribution électrique est également proposé, tel que défini dans la revendication 18.

Selon un mode de réalisation préférentiel, le système peut comprendre des moyens d'envoi de requête d'ouverture d'un élément de commande situé dans le compteur lié à l'installation électrique identifiée comme étant non conforme.

Enfin, selon un autre aspect de l'invention, un produit tangible et non transitoire de programme informatique est proposé, pour identifier de façon automatique les installations susceptibles de présenter une NCE sur un réseau de distribution électrique. Le produit comprend les instructions exécutables par un ou des processeurs pour réaliser les étapes décrites ci-dessus.

La méthode développée et décrite plus en détail ci-après peut être appliquée à des lignes électriques (artères électriques), des postes électriques ou encore à des régions spécifiques regroupant un ou plusieurs clients. Ce regroupement de clients est, ci-après, appelé « étendue électrique » du traitement.

### DESCRIPTION BRÈVE DES DESSINS

Une description détaillée de l'invention sera donnée ci-après en référence avec les dessins suivants:
La **FIG. 1** montre une représentation d'une infrastructure de mesurage avancée dans laquelle s'intègre la méthode pour détecter de façon automatique les installations électriques susceptibles de présenter une NCE.
La **FIG. 2** montre un diagramme, à haut niveau, du processus global dans lequel s'inscrit la méthode d'identification d'installations susceptibles de présenter une NCE, selon un mode de réalisation préférentiel.
La **FIG. 3** montre de façon schématique le flux de données et d'informations associé au processus d'identification d'installations électriques susceptibles de présenter une NCE, selon un mode de réalisation préférentiel.
La **FIG. 4** présente une classification des indicateurs utilisés dans la méthode détection des installations électriques susceptibles de présenter une NCE.
La **FIG. 5** montre un exemple de graphique généré pour une NCE dans une installation polyphasée où un débalancement des profils de courants est constaté.
La **FIG. 6** montre une pluralité de profils de consommation énergétique dont un de ces derniers a des valeurs négatives, indiquant une haute probabilité de raccordements inadéquats.
La **FIG. 7** montre une pluralité de profils de consommation énergétique dont un présente des valeurs supérieures à la valeur maximale normée.

### DESCRIPTION DÉTAILLÉE

Dans le cadre de la description qui suit, un profil ou un profil électrique est défini comme une série temporelle d'un intrant électrique. Cet intrant peut être une consommation énergétique active, une consommation énergétique apparente, une consommation énergétique réactive, une tension, un courant ou tout autre variable de nature électrique. Les profils électriques provenant des installations monophasées et biphasées comprennent au moins des profils de tension (en V) et d'énergie active (en kWh) alors que pour les installations électriques polyphasées, les profils récupérés comprennent l'énergie active (en kWh) totale et par phase électrique (φ_{A}, φ_{B}, φ_{C}), une mesure d'énergie apparente (en kVAh) totale et par phase électrique, une mesure d'énergie réactive (kVARh) totale et par phase électrique, une mesure des tensions (en V) par phase et une mesure des courants (en A) par phase.

Dans le cadre de la description qui suit, les profils utilisés sont produits par un compteur. Par compteur on entend ici une composante de mesure électrique intégrée dans une infrastructure de mesurage avancée qui produit, entre autres, des profils électriques provenant d'une installation électrique reliée à un réseau basse tension (par exemple, un réseau où la tension nominale entre les phases n'excède pas 750V) ou moyenne tension (par exemple, où la tension nominale entre les phases est de plus de 750 V et moins de 44 000 V). Ces compteurs, dont la fonction principale est la mesure d'énergie à des fins de facturation, sont parfois appelés compteur électrique, compteur intelligent, compteur communicant ou compteur de nouvelle génération (CNG).

Dans le cadre de la description qui suit, les profils produits par les compteurs sont traités par des outils informatiques, incluant des algorithmes, permettant d'identifier des installations électriques susceptibles de présenter une non-conformité électrique (NCE). Par outils informatiques, on entend des ordinateurs et/ou des serveurs, des bases de données et des applications logicielles pouvant appliquer des traitements algorithmiques sur les profils électriques. Les ordinateurs et/ou serveurs comprennent une ou des unités de traitement algorithmique, incluant un ou plusieurs processeur(s) et un ou plusieurs moyens d'enregistrement (mémoire). Les outils informatiques peuvent être centralisés ou distribués. Par NCE on entend des anomalies reliées à la position électrique des compteurs, des écarts par rapport aux normes de fonctionnement établies par les utilités électriques et des anomalies associées au processus de mesurage. Cette dernière catégorie est appelée « pertes non techniques » et inclut le vol d'énergie. Ces NCE peuvent être associées aux installations électriques des clients dont la nature du branchement peut être monophasée ou polyphasée.

Dans le cadre de la description qui suit, on entend par client, chacun des usagers branchés sur le réseau électrique basse tension ou moyenne tension. Ce branchement est effectué via une installation électrique. Par installation électrique on entend ici les composantes électriques requises pour l'alimentation des charges électriques d'un client. Sans s'y limiter, la plupart des installations comportent minimalement un compteur adapté à la nature et l'ampleur de la charge, et un ou plusieurs panneaux de distribution aussi adaptés à la nature et l'ampleur de la charge. Les panneaux électriques permettent la distribution d'électricité aux différents équipements électriques du client.

La plupart des solutions existantes pour détecter la présence de NCE, qui peuvent être indicatives de vol d'énergie, impliquent l'ajout d'équipements de sous-mesurage sur le réseau électrique de distribution. Ces équipements, tels que des compteurs ou des capteurs de courant, sont installés en amont des installations électriques des clients et permettent de faire des bilans énergétiques ou de courant dans une cellule électrique ou à un noeud de courant (loi de Kirchhoff). L'infrastructure de sous-mesurage ainsi ajoutée, en plus des compteurs existants associés aux installations électriques des clients (compteurs CNG décrits ci-dessus), implique des coûts substantiels, liés à son acquisition, son déploiement et à son entretien. L'invention décrite dans les paragraphes suivants porte sur une méthode, un système et un produit tangible de programme informatique pour l'identification ou la détection des installations électriques susceptibles de présenter une NCE, et ce sans avoir recours à l'ajout d'équipements de sous-mesurage.

La demande de brevet US 2011/301894 décrit un système qui permet d'identifier les types de charges connectées et utilisées par un client, en comparant les profils électriques avec des profils « signature » d'appareils électro-ménagers connus. L'identification des charges d'un foyer peut ensuite être utilisée pour relayer des messages aux clients ou aux utilités électriques. La technique utilisée pour identifier les charges connectées requière une fréquence d'échantillonnage rapide, par exemple 20ks/s, ce qui est incompatible avec une méthode pour identifier des installations électriques non-conformes d'un réseau de distribution électrique.

La demande de brevet US 2015/323344 décrit une méthode pour détecter une fraude potentielle dans un réseau de distribution, pour ensuite augmenter la fréquence de collecte de données du compteur.

La demande de brevet US 2012/123995 décrit une méthode pour détecter l'utilisation d'une charge alors qu'une requête de non-utilisation de la charge a été établie entre le consommateur et l'utilité électrique.

La demande de brevet US 2009/045976 décrit un système et une méthode conçus pour surveiller les pertes de revenus et les failles de réseau, en utilisant les données de consommation électrique uniquement, sans recours aux signaux de tension, par une méthode d'étalonnage (« benchmarking »).

Le système et la méthode proposés diffèrent des solutions existantes de par le fait qu'ils n'utilisent que les données de compteurs associés aux installations électriques des clients et les outils informatiques développés. Les données transmises par les compteurs et récupérées sous forme de profils sont conditionnées afin d'y appliquer différents traitements algorithmiques, chacun de ces traitements étant lié à un indicateur de NCE donné. Les valeurs générées par les indicateurs permettent aussi de préciser la nature et l'importance d'une NCE. Les résultats des différents traitements algorithmiques sont comparés à des conditions de ciblage, variant d'un indicateur à l'autre. Les installations électriques susceptibles de présenter une NCE sont identifiées à l'aide des indicateurs ayant rencontré ou rempli leurs conditions de ciblage. Certains des indicateurs sont dédiés aux installations électriques monophasées, alors que d'autres sont utilisés pour la détection de NCE dans les installations électriques polyphasées. Les indicateurs peuvent aussi être de nature autonome ou relationnelle. Un indicateur de NCE est considéré comme « autonome » si son traitement algorithmique ne fait intervenir que les données provenant des profils de l'installation analysée. Dans le cas où le traitement algorithmique d'un indicateur de NCE requiert des données provenant des profils d'installations électriquement voisines, cet indicateur est considéré comme étant « relationnel ». On entend ici par installations électriquement voisines, ci-après appelées installations voisines, toutes les installations qui sont reliées sur le même transformateur de distribution, ou sur la même phase électrique ou sur la même ligne électrique voire même le même poste de distribution.

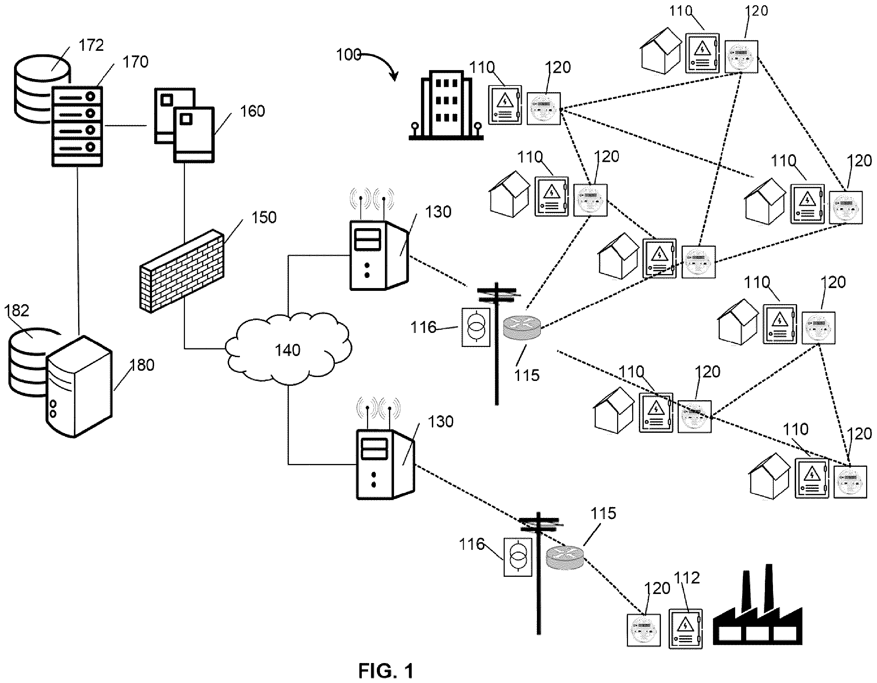

La **FIG. 1** montre les différentes composantes nécessaires à la réalisation de la méthode permettant l'identification des installations électriques susceptibles de présenter une NCE, incluant les composantes en amont du processus. On y montre un réseau de distribution électrique simplifié (100), qui comprend une pluralité d'installations électriques monophasées (110), et des installations électriques polyphasées (112). Bien que peu d'installations électriques soient représentées sur la **FIG.1****,** il est à noter qu'un réseau de distribution électrique peut compter plusieurs milliers voire plusieurs millions d'installations électriques. Les installations électriques sont reliées à des transformateurs (116), qui eux sont reliés à des lignes ou artères électriques du réseau de distribution (100). Ces dernières convergent vers des postes de distribution, non montrés à la **FIG.1****.**

Chaque installation électrique (110, 112 et 120) est reliée à un transformateur de distribution (116). Chaque compteur (120) comprend des moyens de mesurage et des moyens de transmission de données. Les mesures prises par le compteur (données et profils) sont ainsi acheminées vers un système de gestion de données (170), communément appelé MDMS pour *Meter Data Management System.* Chaque compteur comprend également des moyens de commande pour interrompre l'alimentation à l'installation électrique auquel il est relié. Ces moyens peuvent être activés par l'envoi d'un signal du système central de surveillance et de gestion (requête d'ouverture d'un élément de commande situé dans le compteur), vers le compteur. Ainsi, il est possible, via les outils développés pour la présente invention, d'interrompre l'approvisionnement en électricité par l'envoi d'une requête d'ouverture d'un élément de commande situé dans le compteur lié à l'installation électrique déterminée comme étant non conforme.

Le MDMS (170) comprend une base de données (172) pour y sauvegarder les mesures brutes transmises par les compteurs. Le MDMS (170) et la base de données (172) peuvent être localisés sur un ou plusieurs serveurs, localisés dans un même bâtiment, ou encore être distribués, entre plusieurs serveurs, dans différentes localisations, par exemple dans une infrastructure de données infonuagique.

Tel qu'illustré à la **FIG. 1**, les compteurs ne communiquent pas directement avec le MDMS. Les compteurs peuvent se relayer de l'information entre eux ou encore l'envoyer directement à un routeur (115). Ces derniers communiquent avec des collecteurs (130) qui eux transmettent l'information au MDMS (170) via un réseau étendu (140) (Wide Area Network - WAN). Les mesures prises par les compteurs sont ainsi acheminées jusqu'à un système frontal d'acquisition (160), puis au système de gestion des données de mesurage (170). Un système de sécurité pare-feu (150) est employé pour protéger les données provenant des compteurs. Bien sûr, d'autres configurations réseau peuvent aussi être envisagées.

La mise en oeuvre de la méthode d'identification des installations électriques susceptibles de présenter une NCE, est réalisée via des outils informatiques, incluant notamment une application logicielle dédiée. Cette application est déployée dans un système (180) informatique qui peut comprendre une unité de traitement algorithmique, incluant un ou des processeurs et une mémoire de stockage, centrale ou distribuée. Le système (180) peut aussi comprendre un ou des serveurs ainsi qu'une base de données (182). Cette dernière est utilisée pour sauvegarder, entre autres, les profils électriques provenant du MDMS, les données de topologie du réseau de distribution (provenant du Système d'information Géographique, SIG, de l'utilité électrique), les données nominatives liées à un compteur et une installation électrique (aussi appelées « vecteurs-clients ») et les données météorologiques indicatives des conditions météorologiques locales. La base de données peut aussi sauvegarder d'autres informations décrites plus en détail ci-après, incluant par exemple les indicateurs NCE calculés et des identifiants uniques associés aux installations électriques.

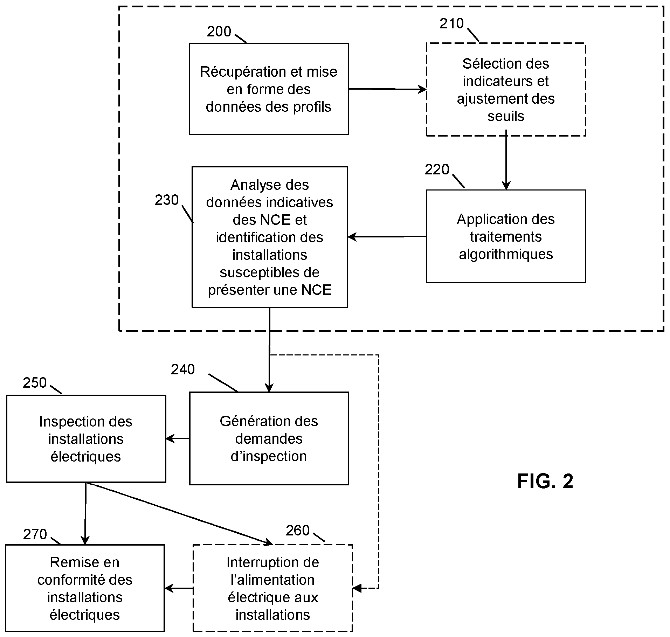

La **FIG. 2** présente le processus global dans lequel s'inscrit la méthode de détection automatique des installations électriques susceptibles de présenter une NCE et ce via l'application de différents traitements algorithmiques associés aux divers indicateurs de NCE. Ce processus se segmente en différentes étapes. La première consiste (200) en la récupération des profils électriques. Cette étape peut aussi inclure l'extraction des données additionnelles, incluant par exemple les données nominatives, la topologie du réseau de distribution électrique, les données météorologiques, et autres données utilisées pour l'application des traitements algorithmiques. Selon un mode de réalisation préférentiel, il est possible de sélectionner l'étendue du traitement autant en termes électriques, que temporel. D'un point de vue électrique, le traitement peut être réalisé à l'échelle du transformateur, d'une phase, d'une ligne ou d'un poste de distribution. Au niveau temporel, la période de traitement peut varier de quelques heures à plusieurs jours voire même quelques mois selon le niveau de précision et le type d'informations recherchées.

La seconde étape (210), optionnelle, permet de sélectionner les indicateurs à calculer de même que le niveau des différents seuils à appliquer pour les conditions de ciblage. Un indicateur de NCE est le résultat d'un traitement algorithmique appliqué sur au moins un profil électrique et qui peut être comparé à une condition de ciblage afin d'identifier une NCE. Selon un mode de réalisation préférentiel, il est possible pour l'usager de sélectionner, via une application dédiée, seulement certains (un sous-ensemble) des indicateurs de NCE à appliquer aux profils analysés, et ce en fonction de la nature de l'installation électrique du client ou encore en fonction du type de recherche désirée. L'application dédiée permet également de modifier les conditions de ciblages, en ajustant les valeurs par défaut des différents seuils et contraintes (voltage, courant, période de temps, nombre d'occurrences, etc.) permettant ainsi de gérer le comportement et la sensibilité des traitements algorithmiques associés aux indicateurs. L'ajustement des seuils peut par exemple être effectué suite à des inspections terrain, confirmant ou infirmant les non-conformités. Pour augmenter ou diminuer la sensibilité de certains indicateurs, on peut ajuster les seuils rétroactivement, selon les résultats d'inspection. Il peut également être possible d'ajuster les seuils par région ou poste de distribution.

La troisième étape (220) permet d'appliquer, aux profils de chacune des installations incluses dans l'étendue électrique sélectionnée (200), les traitements algorithmiques spécifiques à chacun des indicateurs retenus (210). Pour chacun des indicateurs calculés, une vérification est effectuée par rapport aux conditions de ciblage. Lorsqu'au moins un des indicateurs remplit ses conditions de ciblage, l'installation électrique d'où proviennent les profils à l'étude est jugée comme susceptible de présenter une NCE et une inscription est ajoutée au fichier de résultats ou dans une base de données.

La quatrième étape (230) consiste en une analyse des indicateurs ayant rempli leurs conditions de ciblage pour identifier les installations électriques qui sont susceptibles de présenter une NCE. Selon le nombre d'indicateurs, leur occurrence et leur type, un degré de certitude quant à la présence d'une NCE peut être évalué. Selon un mode de réalisation préférentiel et dans certains cas particuliers, l'analyse peut conduire directement à l'interruption de l'alimentation électrique de l'installation (260) dans la mesure où le degré de certitude de la présence d'une NCE est assez élevé. Dans le cas contraire, une analyse détaillée des données de l'installation électrique peut être réalisée afin de confirmer ou d'infirmer la NCE potentielle. L'identification d'une installation électrique susceptible de présenter une NCE ne repose pas uniquement sur la détection d'un seul indicateur observé à un moment précis, mais plutôt sur un ensemble d'indicateurs et/ou une certaine récurrence d'indicateurs. Lorsque la NCE potentielle est maintenue, une demande d'inspection est automatiquement émise (240) et une inspection (250) des installations électriques est effectuée. Finalement, pour les cas de NCE validés par une inspection, une remise en conformité des installations est effectuée (270), précédée ou non d'une interruption de l'alimentation électrique (260) et ce selon le résultat de l'inspection et la nature de la NCE.

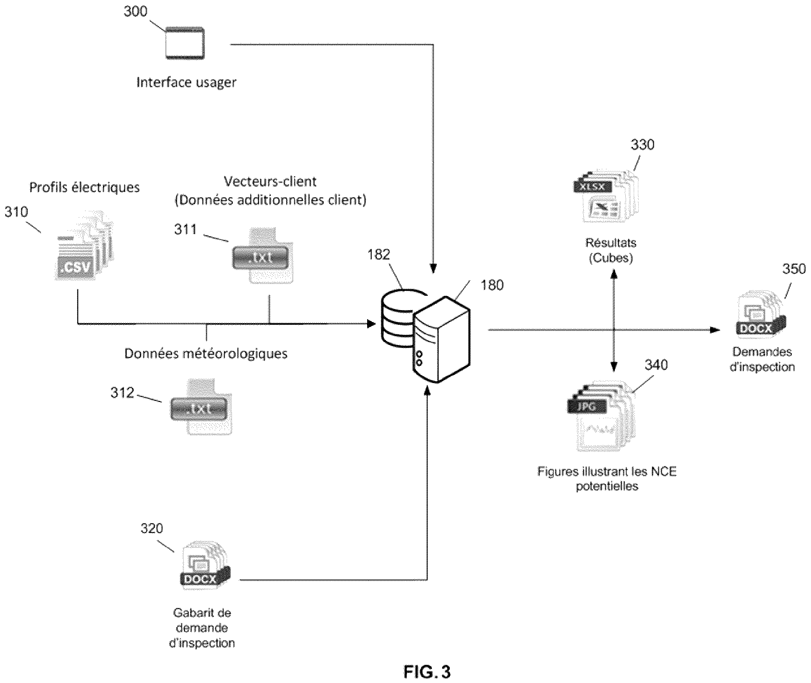

La **FIG. 3** illustre le flux de données et d'information associés au processus d'identification d'installations électriques susceptibles de présenter une NCE, selon un mode de réalisation préférentiel. Quoique les intrants et extrants soient illustrés sous forme de fichiers (csv, txt, docx ou jpg), ils peuvent prendre différentes autres formes par exemple celle provenant ou alimentant une base de données.

Selon un mode de réalisation préférentiel, il est possible de sélectionner, via l'interface usager d'une application dédiée (300), l'ensemble des paramètres de contrôle du traitement. Sans s'y limiter, ces paramètres peuvent correspondre entre autres, à l'étendue électrique et temporelle du traitement à appliquer, aux indicateurs à calculer ainsi que les seuils et contraintes associés à chacun d'eux.

Les profils électriques (310) correspondent aux mesures électriques générées par les compteurs. Les profils peuvent être hiérarchisés afin d'y ajouter la topologie du réseau de distribution électrique, en croisant les données de profils avec les données de topologie du réseau, provenant du SIG de l'utilité électrique. La topologie du réseau permet de connaître les différents liens galvaniques reliant les installations électriques d'un client jusqu'au poste de distribution c.-à-d. transformateur, phase, artère. Certains liens galvaniques peuvent être remis en question via le calcul des indicateurs de positionnement.

Les données nominatives, parfois appelées « vecteurs-clients », (311) contiennent des données permettant de caractériser les installations électriques des clients. Les vecteurs-clients comprennent au moins une des informations suivantes à savoir : la nature de l'installation électrique (monophasée ou polyphasée); le tarif auquel est assujettie l'installation électrique; la vocation de bâtiment (résidentielle, commerciale, institutionnelle ou industrielle) ou encore la source principale d'énergie utilisée pour le chauffage du (des) bâtiment(s). Ces données peuvent servir soit à la sélection des traitements algorithmiques à appliquer aux profils électriques de l'installation ou encore à la validation des NCE potentielles. Les traitements algorithmiques peuvent ainsi croiser les indicateurs de NCE ayant rempli leurs conditions de ciblages avec les données nominatives pour confirmer ou infirmer que les installations électriques identifiées sont bien susceptibles de présenter une NCE. Par exemple, il est possible qu'une installation électrique ne consomme que très peu d'énergie, même en hiver, si le type de chauffage du client est un chauffage au bois ou un gaz, versus des installations voisines dont le mode de chauffage est électrique.

Les données météorologiques (312) comprennent minimalement un profil de température extérieure locale correspondant à la période d'étude (date et heure pour spécifier l'étendue temporelle). Les données météorologiques peuvent être utilisées dans le traitement algorithmique associé à certains indicateurs ou encore peuvent servir à confirmer ou infirmer une NCE potentielle. Encore ici, une pointe de consommation pour des installations d'une région donnée peut s'expliquer par une période de grand froid. Ainsi, une NCE détectée peut être validée avec des données additionnelles (nominatives et météorologiques).

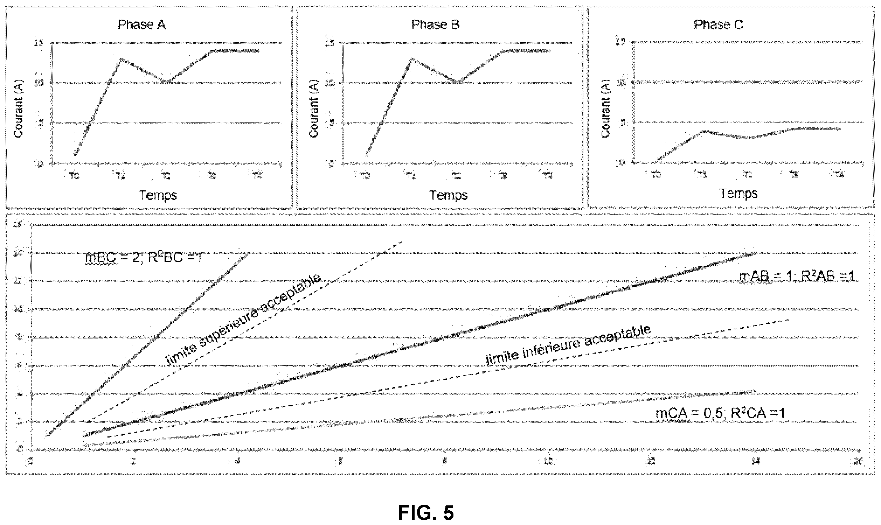

À la fin du traitement, selon un mode de réalisation préférentiel, les résultats sont colligés dans une structure de données ou structure de résultats, aussi appelée « cube » (330). La structure de données comprend au moins pour chacune des installations susceptibles de présenter une NCE, la liste des indicateurs ayant rempli leurs conditions de ciblage, la valeur des indicateurs de même qu'un ou des identifiants uniques permettant de distinguer les installations sur un réseau de distribution électrique. L'identifiant unique peut comprendre par exemple l'adresse civique ou encore un numéro de série du compteur associé à l'installation. Certaines informations provenant des données nominatives (311) peuvent aussi être ajoutées à la structure de résultats afin de faciliter la production des demandes d'inspection. La structure des résultats peut aussi comprendre des figures ou graphiques permettant de représenter les indicateurs de NCE ayant rempli les conditions de ciblage, comme ceux montrés aux figures 5, 6 et 7. Le contenu de la structure peut être exporté dans différents formats de fichiers ou encore sauvegardé directement dans une base de données. Les résultats peuvent être regroupés par lignes, par postes de distribution ou encore par régions, selon l'étendue électrique du traitement.

Dans l'éventualité où aucune analyse ou information additionnelle ne permet d'infirmer une NCE potentielle associée à l'installation électrique d'un client, une demande d'inspection (350) de ladite installation électrique est générée automatiquement par le système, via l'application logicielle dédiée. L'utilisation d'un gabarit (320) pro formaté permet la production automatique d'une demande d'inspection. Cette demande contient les informations requises à l'inspection soit minimalement, les informations nominatives du client, la nature de la NCE suspectée et le niveau de priorité de l'inspection attribué automatiquement. La priorité peut être déterminée en fonction du degré de certitude quant à l'existence de la ou des NCE pour ladite installation. Une figure ou un graphique (340) illustrant le phénomène ayant conduit à l'identification de la NCE potentielle peut aussi être ajouté à la demande d'inspection. C'est l'inspection d'une installation qui fournira la confirmation finale et sans équivoque de la présence d'une NCE.

Faisant suite aux résultats d'inspections obtenus, une rétroaction des valeurs par défaut de seuils et contraintes des indicateurs de NCE peut être faite afin d'augmenter le rendement global de la méthode de détection. Ce rendement, exprimé en pourcentage, est défini comme étant le rapport du nombre de cas de NCE confirmées sur le nombre total de cas de NCE qui ont fait l'objet d'une inspection ou d'une interruption de l'alimentation électrique.

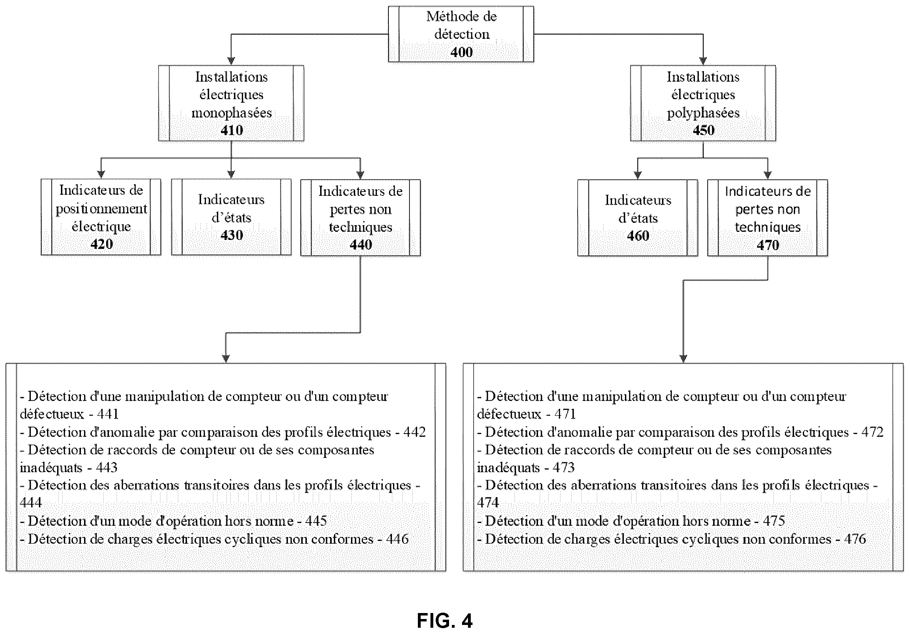

La **FIG.4** présente une classification des différents indicateurs de NCE, selon un mode de réalisation préférentiel de la méthode proposée (400). Le premier niveau de classification permet de distinguer les indicateurs de NCE appliqués aux installations électriques monophasées (410) et polyphasées (450). Sous ces niveaux, trois classes d'indicateurs peuvent être définies soit une première classe d'indicateurs appelée « indicateurs de positionnement électrique » (420); une seconde classe d'indicateurs appelée « indicateurs d'état » (430 et 460); et une troisième classe d'indicateurs appelée « indicateurs de pertes non techniques » (440 et 470). Cette dernière classe regroupe les anomalies qui affectent le mesurage de l'énergie électrique, et comprend plusieurs sous-classes d'indicateurs.

Les « indicateurs de positionnement électrique » (420), propres aux installations monophasées, permettent, via une analyse statistique et électrique, de confirmer ou d'infirmer l'exactitude du lien galvanique qui relie l'installation électrique d'un client (120 de la **FIG.1**) à son transformateur de distribution (116 de la **FIG.1**) et son appartenance à la ligne à l'étude. Dans la mesure où le lien galvanique est validé, aucune attribution particulière n'est faite à l'installation électrique. Dans le cas contraire, si les indicateurs de positionnement montrent que l'installation du client semble tout de même appartenir à la ligne électrique analysée, alors l'installation est affublée de la caractéristique « installation ou client mal localisé ». Si les indicateurs montrent au contraire que l'installation du client ne semble pas appartenir à la ligne électrique analysée, l'installation est affublée du statut « OUT », c.-à-d. installation n'appartenant pas à la ligne étudiée. La méthode peut également comprendre une étape de valider, à partir des données indicatives de positionnement calculées, une probabilité que les installations électriques identifiées soient des installations non conformes.

« Les indicateurs d'états » (430 et 460) sont quant à eux des indicateurs qui permettent d'avoir une meilleure connaissance des conditions d'opération électrique de l'installation d'un client. Ces indicateurs, pris individuellement ou dans leur globalité, peuvent permettre de confirmer ou infirmer l'existence d'une NCE potentielle. La présence d'un indicateur d'état dans la structure de résultats peut aussi mener, directement, et après analyse, à l'existence d'une NCE. Par exemple, un indicateur d'état peut mettre en évidence une absence anormale de données dans les profils de tension ou de consommation d'une installation monophasée ou encore montrer un débalancement de tension ou de courant dans une installation polyphasée. Les indicateurs d'états peuvent comprendre un ou plusieurs des indicateurs suivants : taux de captation de données énergétiques; taux de captation des données de tension; débalancement en tension; débalancement en courant; rapport de l'énergie apparente et active. Tout comme pour les indicateurs de positionnement, on peut valider, à partir des données indicatives d'états calculées, une probabilité que les installations électriques identifiées soient des installations non conformes.

« Les indicateurs de pertes non techniques » (440 et 470) sont ceux qui révèlent, via l'exécution d'algorithmes, des anomalies électriques potentielles qui affectent le mesurage de l'énergie électrique consommée. Cette classe peut être subdivisée en sous-classes. Dans la représentation de la **FIG.4****,** six (6) sous-classes ont été constituées. Précisions ici, que d'autres sous-classes d'indicateurs NCE peuvent être définies.

Les différentes sous-classes d'indicateurs de pertes techniques incluent : la détection d'une manipulation de compteur ou d'un compteur défectueux (441 et 471); la détection d'anomalies par comparaison de profils électriques (442 et 472); la détection de raccords de compteur ou de ses composantes inadéquats (443 et 473); la détection des aberrations transitoires dans les profils électriques (444 et 474); la détection d'un mode d'opération hors norme (445 et 475); et la détection de charges électriques cycliques non conformes (446 et 476).

Les prochains paragraphes décrivent plus en détail les différentes sous-classes d'indicateurs de pertes non techniques. Il est ici utile de préciser qu'un indicateur peut se retrouver dans une ou plusieurs sous-classes. C'est entre autres le cas de l'indicateur qui détecte les valeurs négatives dans les profils de consommation active. L'existence des valeurs négatives peut être attribuée à la sous-classe « détection d'une manipulation de compteur ou d'un compteur défectueux », et ce, tout en faisant aussi partie de la sous-classe des indicateurs révélant une opération hors norme.

Concernant une première sous-classe « détection d'une manipulation de compteur ou d'un compteur défectueux » (441 et 471), cette sous-classe regroupe tous les indicateurs dont le résultat du traitement algorithmique peut s'expliquer par une manipulation du compteur ou un mauvais fonctionnement de ce dernier. Par exemple, un des indicateurs autonomes de cette sous-classe analyse le profil de tension d'une installation monophasée. Si ce profil montre une tension moyenne de l'ordre de 50 % de la tension nominale, il devient raisonnable de croire que, soit le compteur est défectueux ou encore qu'une manipulation des raccords du bobinage de tension a été intentionnellement faite. Par contre si le niveau de tension est variable dans le temps et de surcroît arbitraire, on peut suspecter un mauvais fonctionnement du compteur. Sans s'y limiter, les indicateurs de cette sous-classe peuvent comprendre : altération du bobinage de tension; données identiques en énergie; données identiques en tension; résistance en série sur transformateur de courant; et courant triphasé nul avec consommation non nulle.

La seconde sous-classe appelée « détection d'anomalies par comparaison des profils électriques » (442 et 472) comprend des indicateurs de NCE de type « relationnel » pour les installations monophasées et de type « relationnel » ou « autonome » pour les installations électriques polyphasées. De façon générale, dans cette sous-classe, le traitement algorithmique des indicateurs a pour but d'identifier les différences entre les divers profils provenant des installations électriquement voisines.

Par exemple, un des indicateurs relationnels monophasés de cette sous-classe analyse les profils de tension moyens des installations électriques sur une certaine période de temps. Dans l'éventualité où l'écart maximal entre les niveaux de tension moyens des installations est supérieur à un certain seuil et qu'aucun paramètre électrique ne le justifie, une NCE potentielle sera attribuée à l'installation sous analyse.

Un autre exemple est celui d'un indicateur, appelé ratio de courant, qui analyse les profils de courant de chacune des phases d'alimentation d'une installation polyphasée. Cet indicateur permet d'identifier les compteurs polyphasés dont au moins un des profils de courant a un niveau moyen différent des autres compteurs, et ce, tout en ayant un profil presque identique. Tel que montré à la **FIG. 5****,** cet indicateur fait intervenir, dans son traitement algorithmique, les notions statistiques de pentes (m_{AB}, m_{BC}, m_{CA}) et de facteurs de détermination (R²_{AB}, R²_{BC}, R²_{CA}) appliqués aux couplets des différentes valeurs de profils de courant. Lorsque la valeur du facteur de détermination avoisine l'unité et que de la pente est en dehors des seuils, une NCE potentielle est attribuée à l'installation sous analyse. Les trois graphiques du haut de la **FIG. 5** montrent un cas d'installation électrique triphasée pour laquelle les profils de courant sont semblables pour les phases A, B et C. Cependant, ces mêmes graphiques montrent aussi un niveau de courant inférieur sur la phase C. Ces graphiques illustrent qu'il peut y avoir une NCE potentielle dans les composantes de mesurage de l'installation électrique. La **FIG. 5** présente aussi un exemple d'un graphique pouvant être généré automatiquement (image du bas) et montrant les différentes valeurs statistiques utilisées. Sans s'y limiter, les indicateurs de cette seconde sous-classe peuvent comprendre : consommation nocturne; écart de tension des valeurs moyennes monophasées; écart de tension des valeurs moyennes interphases; écart de tension des valeurs moyennes inter-clients; écart de tension des valeurs moyennes sous un transformateur polyphasées; niveau de tension à consommation nulle; ratio de courant; et perte et retour de tension non synchronisés.

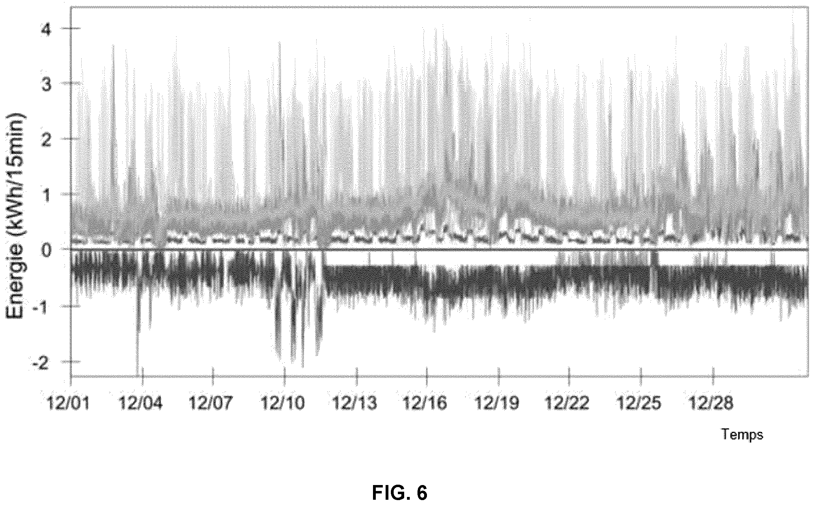

Une troisième sous-classe appelée « détection de raccords de compteur ou de ses composantes inadéquats » (443 et 473) permet de détecter les installations électriques dont le raccord électrique du compteur (installation monophasée) ou d'une composante de l'installation de mesurage (installation polyphasée) est inadéquat. Un exemple d'indicateur se retrouvant dans cette sous-classe est celui qui vise à détecter, sous des conditions précises, des valeurs négatives dans les profils de consommation des installations. L'existence de ces valeurs dans les profils de consommation est, avec un haut taux de probabilité, due soit à une inversion ou à une demi-inversion des raccords du compteur (installation monophasée) ou à une inversion des sous-composantes de mesurage (installation polyphasée). Précisons ici, que sous certaines conditions, il est possible que des valeurs d'énergie négatives soient constatées dans les profils de consommation des installations électriques des producteurs, des transporteurs ou des distributeurs d'électricité. Pour cette raison, ces derniers sont exclus de ce type d'analyse. La **FIG. 6** montre les profils de consommation électriques de quelques installations de clients monophasés sous un même transformateur de distribution. L'une de ces installations montre des valeurs négatives sur toute la durée de la période d'analyse, ce qui est impossible et donc indicatif d'une anomalie. D'autres indicateurs de cette sous-classe incluent : une absence de courant, une absence de tension, ou une tension nulle avec courant.

Une quatrième sous-classe appelée « détection des aberrations transitoires dans les profils électriques » (444 et 474) comprend des indicateurs d'une variation brusque et momentanée d'une variable électrique qui ne peut être expliquée ni par d'autres variables électriques locales ou voisines ni par les informations du vecteur-client. Cette sous-classe inclut l'indicateur destiné à l'identification des grands écarts de tension. Par exemple, les traitements algorithmiques liés aux grands écarts de tension peuvent inclure des étapes de calculer des écarts de tension, pour un profil donné, entre deux périodes de mesure consécutives; de retenir les écarts qui sont au-dessus ou en deçà de seuils prédéterminés, de calculer l'énergie estimée requise pour ces écarts, et ensuite, de les comparer aux valeurs d'énergie mesurées pour ces périodes. Une non-conformité « grand écart de tension » est détectée pour les installations ayant des variations de tension ne correspondant pas à l'appel énergétique qui devrait y être associé.

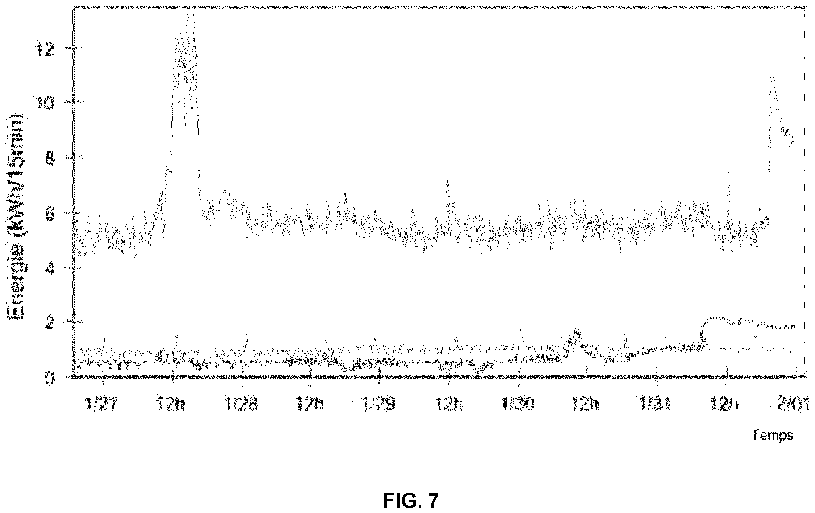

Une cinquième sous-classe est appelée « détection d'un mode d'opération hors norme » (445 et 475), et dans laquelle les indicateurs identifient, dans les profils électriques, les conditions d'opération jugées en dehors des normes d'exploitation propres à chaque utilité électrique. Par exemple, les traitements algorithmiques associés aux indicateurs de tension hors norme peuvent comprendre des étapes de calculer la tension moyenne des profils pour des profils dont une valeur de courant est non-nulle; et comparer la tension moyenne des profils à des tensions minimale ou maximale prédéterminées. La **FIG.7** donne en exemple graphique d'une installation monophasée qui, en pointe, consomme plus 14 kWh/15 minutes alors que l'installation a une capacité maximale de 12 kWh/15 minutes à 100 % de sa charge utile (indicateur d'énergie active consommée). Cette sous-classe d'indicateurs permet aussi d'identifier les valeurs moyennes, dans les profils de tension, qui dépassent les valeurs en conditions d'opération marginales définies par les opérateurs de réseaux électriques. Les indicateurs de cette catégorie peuvent inclure un indicateur de chauffage biénergie; une puissance de pointe hors norme; une tension moyenne hors norme; un indicateur de transformateur à raccordement unique; un facteur de détermination disparate; une validation de l'énergie active consommée; ou encore une tension hors norme avec courant.

Enfin, une sixième sous-classe appelée « détection de charges électriques cycliques non conformes » (446 et 476) comprend des indicateurs qui permettent d'identifier, via l'analyse des profils de tension et d'énergie, la présence de charges cycliques non conformes. Par charges cycliques non conformes, on entend ici toutes les charges cycliques non correctement mesurées par le compteur ou ses composantes, et ce via une altération de ces derniers ou de leur environnement. Sans s'y limiter, le traitement algorithmique lié à ce type d'indicateurs peut, entre autres, inclure le calcul de la Transformée de Fourier Rapide (Fast Fourier Transform - FFT), le calcul de corrélation et d'autocorrélation de profils, le calcul de certaines occurrences, l'analyse et le traitement des profils de tension et énergie. Le traitement algorithmique des indicateurs de cette sous-classe est réalisé pour des périodes jugées optimales à la recherche spécifique de NCE sur le réseau de distribution.

Sans égard à la classification, il est important de noter que l'application et la gestion des traitements algorithmiques proposés par la présente méthode (400) sont complexes, étant donné le grand volume de profils à traiter et le nombre d'indicateurs à calculer. Les données de centaines de milliers, voire de quelques millions d'installations électriques sont analysées. Ces traitements ne peuvent évidemment pas être réalisés manuellement. Une application logicielle dédiée, comprenant des instructions exécutables par un ou des processeurs, comprenant une ou des UAL (unités arithmétique et logique), est essentielle à la réalisation de la méthode proposée.

En résumé, la méthode (400) et le système décrit ci-dessus, qui inclut un produit tangible et non-transitoire de programme informatique (application informatique), permettent d'identifier les installations électriques étant susceptibles de présenter une NCE. Tel que décrit ci-dessus, un indicateur est le résultat de l'exécution d'un traitement algorithmique appliqué à des profils électriques et thermiques (base de données météorologiques). L'estimation de certains indicateurs et la validation de l'existence de certaines NCE sont aussi rendues possibles via le recours à une base de données supplémentaire qui contient les données nominatives (ou vecteurs-clients). Comme extrants, l'application dédiée permet d'identifier les installations électriques nécessitant une inspection terrain ou, selon le degré de certitude de la NCE, une interruption automatique de l'alimentation en électricité d'une installation.

La méthode et le système proposés ne requièrent nullement que d'autres composantes soient installées sur le réseau de distribution. Cette caractéristique innovante permet de diminuer de façon importante les coûts de déploiement (acquisition) et d'utilisation (remplacement et entretien) de la méthode de détection, par rapport aux méthodes existantes. La méthode et le système permettent également de traiter de grandes quantités de profils, associés à une pluralité d'installations électriques de façon automatisée, avec peu ou pas d'interventions humaines. La méthode et le système proposés permettent d'automatiser le processus de détection et d'identification d'installations électriques susceptibles de présenter une NCE et ce de la collecte des profils, à la sélection des indicateurs à appliquer, aux calculs algorithmiques associés, à l'identification des installations électriques, et jusqu'à l'interruption automatique (au besoin) de l'alimentation des installations électriques confirmées comme non conformes.

## Revendications

1. Méthode pour identifier de façon automatique des installations électriques susceptibles de présenter une non-conformité électrique (NCE) sur un réseau de distribution électrique (100), les installations électriques (110, 112) étant reliées à des compteurs (120), la méthode comprenant :
a) Récupérer (200) d'un système de gestion de données (170) des profils électriques (310) associés aux installations électriques, les profils étant générés par lesdits compteurs déployés par des utilités électriques pour fins de facturation à partir de mesures prises par lesdits compteurs, les profils étant échelonnés dans le temps ;
la méthode étant **caractérisée en ce qu'**elle comprend les étapes de :
b) récupérer des données nominatives (311) caractérisant les installations électriques à partir d'une base de données (182), les données nominatives comprenant, pour chacune des installations électriques, au moins une de :
- nature de l'installation électrique parmi monophasée ou polyphasée;
- tarif auquel est assujettie l'installation électrique;
- vocation du ou des bâtiments associé(s) à l'installation électrique, parmi une vocation résidentielle, une vocation commerciale, une vocation institutionnelle ou une vocation industrielle; et
- source principale d'énergie utilisée pour chauffer le ou les bâtiments,
c) sélectionner (210) une partie des indicateurs de NCE à appliquer aux profils en fonction des informations contenues dans les données nominatives, parmi des indicateurs de positionnement, d'état ou de pertes non techniques ;
d) appliquer, avec des outils informatiques, des traitements algorithmiques associés aux indicateurs de NCE sélectionnés, en fonction de conditions de ciblage, sur les profils électriques récupérés à l'étape a), pour obtenir des données indicatives de différents types de NCE ;
e) identifier, à partir des données obtenues à l'étape d), lesdites installations électriques susceptibles de présenter une NCE, lorsque les conditions de ciblage sont rencontrées ;
f) confirmer ou infirmer que les installations électriques identifiées sont bien susceptibles de présenter une NCE, en croisant lesdites informations nominatives et les indicateurs de NCE ayant rencontré leurs conditions de ciblage ; et
g) générer une structure de résultats (330) comprenant les données indicatives des différents types de NCE potentielles identifiées pour chaque installation électrique confirmée,
ladite méthode ne requérant que les profils électriques générés par les compteurs et les outils informatiques pour identifier les installations électriques susceptibles d'être non conformes, sans recours à aucun autre équipement de sous mesurage.

2. La méthode selon la revendication 1, comprenant en outre :
récupérer des données météorologiques (312) d'une base de données météorologiques; et
confirmer ou infirmer que les installations électriques identifiées sont bien susceptibles de présenter une NCE, en croisant lesdites données météorologiques et les indicateurs de NCE ayant rencontré leurs conditions de ciblages,
les données météorologiques comprenant au moins une des informations suivantes : une température extérieure locale; une date; une heure déterminée au moment où les profils ont été générés.

3. La méthode selon l'une quelconque des revendications 2, comprenant en outre:
identifier la nature des installations électriques comme étant monophasées ou polyphasées, basé sur les profils récupérés et/ou sur les informations nominatives,
les profils électriques provenant des installations monophasées et biphasées comprenant au moins des profils de tension (en V) et d'énergie active (en kWh) ; et
les profils récupérés provenant des installations électriques polyphasées comprenant l'énergie active (en kWh) totale et par phase électrique (φ_{A}, φ_{B}, φ_{C}), une mesure d'énergie apparente (en kVAh) totale et par phase électrique, une mesure d'énergie réactive (kVARh) totale et par phase électrique, une mesure des tensions (en V) par phase et une mesure des courants (en A) par phase.

4. La méthode selon l'une quelconque des revendications 1 à 3, dans laquelle :
une partie des indicateurs de NCE sont des indicateurs autonomes, soit ceux dont les traitements algorithmiques ne font intervenir que les données provenant des profils de l'installation analysée et
une partie des indicateurs de NCE sont des indicateurs relationnels, soit ceux qui font intervenir les profils des installations voisines, c.-à-d. qui sont reliées à un même transformateur de distribution, à une même phase électrique, à une même ligne électrique ou à un même poste de distribution.

5. La méthode selon l'une quelconque des revendications 1 à 4, dans laquelle à l'étape d), une partie des traitements algorithmiques sont associés à une première classe d'indicateurs NCE appelée indicateurs de positionnement (420), la méthode comprenant une action de calculer au moins un indicateur de positionnement, et déterminer si :
- une installation électrique donnée est située sur une ligne électrique analysée, mais est reliée à un autre transformateur que celui défini dans les données nominatives; ou
- une installation donnée n'est pas raccordée à la ligne électrique analysée ;
la méthode comprenant en outre une étape de valider, à partir des données indicatives de positionnement calculées, une probabilité que les installations électriques identifiées à l'étape e) soient des installations non conformes.

6. La méthode selon l'une quelconque des revendications 1 à 5, dans laquelle à l'étape d), une partie des traitements algorithmiques sont associés à une seconde classe d'indicateurs NCE appelée indicateurs d'états (430, 460), la méthode comprenant une action de calculer au moins un des indicateurs d'états suivants:
- taux de captation de données énergétiques;
- taux de captation des données de tension;
- débalancement en tension;
- débalancement en courant;
- rapport de l'énergie apparente et active;
la méthode comprenant en outre une étape de valider, à partir des données indicatives d'états calculées, une probabilité que les installations électriques identifiées à l'étape e) soient des installations non conformes.

7. La méthode selon l'une quelconque des revendications 1 à 6, dans laquelle à l'étape d), une partie des traitements algorithmiques sont associés à première sous-classe d'indicateurs de pertes non techniques (440, 470), la méthode comprenant une action de calculer au moins un indicateur d'une manipulation de compteur ou de compteur défectueux (441, 471) parmi :
- altération du bobinage de tension ;
- données identiques en énergie ;
- données identiques en tension ;
- résistance en série sur transformateur de courant ; et
- courant triphasé nul avec consommation non nulle;
la méthode comprenant en outre une étape de valider, à partir des données indicatives de pertes non techniques calculées, une probabilité que les installations électriques identifiées à l'étape e) soient des installations non conformes.

8. La méthode selon l'une quelconque des revendications 1 à 7, dans laquelle à l'étape d), une partie des traitements algorithmiques sont associés à une seconde sous-classe d'indicateurs de pertes non techniques, la méthode comprenant une action de calculer au moins un indicateur d'anomalies par comparaison (442, 472) parmi :
- consommation nocturne ;
- écart de tension des valeurs moyennes monophasées ;
- écart de tension des valeurs moyennes interphases ;
- écart de tension des valeurs moyennes inter-clients ;
- écart de tension des valeurs moyennes sous un transformateur polyphasées ;
- niveau de tension à consommation nulle ;
- ratio de courant ;
- perte et retour de tension non synchronisés; et
la méthode comprenant en outre une étape de valider, à partir des données indicatives d'anomalies par comparaison, une probabilité que les installations électriques identifiées à l'étape e) soient des installations non conformes.

9. La méthode selon l'une quelconque des revendications 1 à 8, dans laquelle à l'étape d), une partie des traitements algorithmiques sont associés à une troisième sous-classe d'indicateurs de pertes non techniques, la méthode comprenant une action de calculer au moins un indicateur de raccord de compteur ou de composants inadéquats (443, 473) parmi :
- absence de courant ;
- absence de tension ;
- données en énergie négatives ;
- tension nulle avec courant;
la méthode comprenant en outre une étape de valider, à partir des données indicatives d'un raccord de compteur ou de ses composants inadéquats, une probabilité que les installations électriques identifiées à l'étape e) soient des installations non conformes.

10. La méthode selon l'une quelconque des revendications 1 à 9, dans laquelle à l'étape d), une partie des traitements algorithmiques sont associés à une quatrième sous-classe d'indicateurs de pertes non techniques, la méthode comprenant une action de calculer un indicateur d'aberrations transitoires (444, 474) par l'identification de grands écarts de tensions sur lesdits profils,
la méthode comprenant en outre une étape de valider, à partir des données indicatives d'aberrations transitoires, une probabilité que les installations électriques identifiées à l'étape e) soient des installations non conformes.

11. La méthode selon l'une quelconque des revendications 1 à 10, dans laquelle à l'étape d), une partie des traitements algorithmiques sont associés à une cinquième sous-classe d'indicateurs de pertes non techniques, la méthode comprenant une action de calculer au moins un indicateur de mode d'opération hors norme (445, 475) parmi :
- indicateur de chauffage biénergie ;
- puissance de pointe hors norme ;
- tension moyenne hors norme ;
- transformateur à raccordement unique ;
- facteur de détermination disparate;
- validation de l'énergie active consommée ;
- tension hors norme avec courant;
la méthode comprenant en outre une étape de valider, à partir des données indicatives de mode d'opération hors norme, une probabilité que les installations électriques identifiées à l'étape e) soient des installations non conformes.

12. La méthode selon l'une quelconque des revendications 1 à 11, dans laquelle à l'étape d), une partie des traitements algorithmiques sont associés à une sixième sous-classe d'indicateurs de pertes non techniques, la méthode comprenant une action de calculer au moins un indicateur de détection de charges électriques cycliques non conformes (446, 476) parmi :
- transformation de Fourrier appliquée sur des mesures de tension et d'énergie pour des périodes (cycles) données;
- présence de tension cyclique sans appel de puissance;
la méthode comprenant en outre une étape de valider, à partir des données indicatives de charges cycliques non conformes, une probabilité que les installations électriques identifiées à l'étape e) soient des installations non conformes.

13. La méthode selon l'une quelconque des revendications 1 à 12, comprenant une étape de générer des graphiques (340) représentant visuellement les indicateurs de NCE ayant rencontrés les conditions de ciblage.

14. La méthode selon l'une quelconque des revendications 1 à 13, comprenant une étape de générer, via une application logicielle, des demandes d'inspection (350) des installations électriques identifiées comme étant susceptibles de présenter une NCE.

15. La méthode selon l'une quelconque des revendications 1 à 14, comprenant une étape d'attribuer une priorité aux installations électriques identifiées comme susceptibles de présenter une NCE, en fonction d'un degré de certitude quant à l'existence de NCE pour une installation donnée, le degré de certitude étant lié au nombre, à l'occurrence et au type d'indicateurs de NCE ayant rencontré les conditions de ciblage.

16. La méthode selon l'une quelconque des revendications 1 à 15, dans laquelle les mesures constituant les profils électriques sont prises par les compteurs au moins une fois l'heure et sont acheminées par les compteurs vers le système de gestion de données.

17. La méthode selon l'une quelconque des revendications 1 à 16, comprenant une étape d'interruption automatique de l'approvisionnement en électricité (260) pour au moins certaines des installations électriques identifiées à l'étape e), l'étape d'interrompre l'approvisionnement en électricité implique l'envoi d'une requête d'ouverture d'un élément de commande situé dans le compteur lié à l'installation électrique déterminée comme étant non conforme.

18. Un système pour identifier de façon automatique des installations électriques étant susceptibles de présenter une non-conformité électrique (NCE) sur un réseau de distribution électrique (100), le système comprenant un système de gestion de données, des compteurs (120) déployés par des utilités électriques pour fin de facturation à partir de mesures prises par lesdits compteurs, et au moins une unité de traitement algorithmique (180) ayant un processeur et une mémoire en communication avec le processeur, la mémoire comprenant des instructions exécutables par le processeur pour :
a) récupérer du système de gestion de données des profils électriques (310) associés aux installations électriques (110, 112), les profils étant générés par les compteurs (120) et les profils étant échelonnés dans le temps ;
le système étant **caractérisé en ce que** la mémoire comprend des instructions exécutables par le processeur pour:
b) récupérer des données nominatives (111) caractérisant les installations électriques à partir d'une base de données (182), les données nominatives comprenant, pour chacune des installations électriques, au moins une de :
- nature de l'installation électrique parmi monophasée ou polyphasée;
- tarif auquel est assujettie l'installation électrique;
- vocation du ou des bâtiments associé(s) à l'installation électrique, parmi une vocation résidentielle, une vocation commerciale, une vocation institutionnelle ou une vocation industrielle; et
- source principale d'énergie utilisée pour chauffer le ou les bâtiments,
c) sélectionner une partie des indicateurs de NCE à appliquer aux profils en fonction des informations contenues dans les données nominatives, parmi des indicateurs de positionnement, d'état ou de pertes non techniques;
d) appliquer des traitements algorithmiques associés aux indicateurs de NCE sélectionnés, en fonction de conditions de ciblage, sur les profils électriques récupérés à l'étape a), pour obtenir des données indicatives de différents types de NCE ;
e) identifier, à partir des données obtenues à l'étape d), lesdites installations électriques susceptibles de présenter une NCE, lorsque les conditions de ciblage sont rencontrées ;
f) confirmer ou infirmer que les installations électriques identifiées sont bien susceptibles de présenter une NCE, en croisant lesdites informations nominatives et les indicateurs de NCE ayant rencontré leurs conditions de ciblage ; et
g) générer une structure de résultats (330) comprenant les données indicatives des différents types de NCE potentielles identifiées pour chaque installation électrique confirmée,
ledit système ne requérant que les profils générés par les compteurs et l'au moins une unité(s) de traitement algorithmique pour identifier les installations électriques susceptibles d'être non conformes, sans recours à aucun autre équipement de sous mesurage.

19. Le système selon la revendication 18, comprenant une ou des bases de données (172, 182) pour sauvegarder : les profils électriques générés par les compteurs; et des identifiants uniques associés aux installations électriques du réseau qui sont susceptibles de présenter une NCE.

20. Le système selon la revendication 19, comprenant au moins un écran relié directement ou indirectement à l'au moins une unité(s) de traitement, la mémoire comprenant des instructions exécutables par le processeur pour afficher sur l'écran une interface utilisateur permettant de sélectionner des indicateurs de NCE à appliquer sur les profils électriques, de sélectionner l'ensemble ou une partie des profils sur lesquels les traitements algorithmiques associés aux indicateurs sélectionnés doivent être appliqués et d'afficher les identifiants uniques des installations électriques identifiées comme susceptibles d'être non-conformes.

21. Le système selon la revendication 20, comprenant des moyens d'envoi de requête d'ouverture d'un élément de commande situé dans le compteur lié à l'installation électrique déterminée comme étant non conforme.

## Patentansprüche

1. Verfahren zur automatischen Identifizierung von elektrischen Installationen, die eine elektrische Nichtkonformität (NCE) in einem elektrischen Verteilungsnetzes (100) aufweisen können, wobei die elektrischen Installationen (110, 112) mit Zählern (120) verbunden sind und das Verfahren Folgendes umfasst:
a) Abrufen (200) von elektrischen Profilen (310), die mit den elektrischen Installationen verbunden sind, von einem Datenverwaltungssystem (170), wobei die Profile durch die von Energieversorgungsunternehmen eingesetzten Zähler zu Abrechnungszwecken auf der Grundlage von Messungen erzeugt werden, die von den Zählern vorgenommen werden, wobei die Profile zeitlich gestaffelt sind;
wobei das Verfahren **dadurch gekennzeichnet ist, dass** es die folgenden Schritte umfasst:
b) Abrufen von nominativen Daten (311), die die elektrischen Installationen charakterisieren, aus einer Datenbank (182), wobei die nominativen Daten für jede der elektrischen Installationen mindestens eines der Folgenden enthalten:
- Art der elektrischen Installation: einphasig oder mehrphasig;
- Tarif, dem die elektrische Installation unterliegt;
- Zweckbestimmung des Gebäudes/der Gebäude, das/die mit der elektrischen Installation verbunden ist/sind, wobei es sich um eine Wohnnutzung, eine gewerbliche Nutzung, eine institutionelle Nutzung oder eine industrielle Nutzung handeln kann; und
- Hauptenergiequelle, die zum Beheizen des Gebäudes bzw. der Gebäude verwendet wird,
c) Auswählen (210) eines Teils der auf die Profile anzuwendenden NCE-Indikatoren auf der Grundlage der in den nominativen Daten enthaltenen Informationen aus nicht-technischen Positions-, Zustands- oder Verlustindikatoren;
d) Anwenden von algorithmischen Verarbeitungen, die mit den ausgewählten NCE-Indikatoren verbunden sind, mithilfe von Computertools entsprechend den Zielbedingungen auf die in Schritt a) abgerufenen elektrischen Profile, um indikative Daten zu erhalten, die auf verschiedene Arten von NCE hindeuten;
e) anhand der in Schritt d) erhaltenen Daten die besagten elektrischen Installationen zu identifizieren, die möglicherweise eine NCE aufweisen, wenn die Zielbedingungen erfüllt sind;
f) Bestätigen oder Verneinen, dass die identifizierten elektrischen Installationen wahrscheinlich eine NCE aufweisen, indem man diese nominativen Informationen mit den NCE-Indikatoren, die ihre Zielbedingungen erfüllt haben, abgleicht; und
g) Generieren einer Ergebnisstruktur (330), die indikative Daten für die verschiedenen Arten von potenziellen NCE enthält, die für jede bestätigte elektrische Installation identifiziert wurden,
das Verfahren erfordert nur die von den Zählern erzeugten elektrischen Profile und Computertools, um elektrische Installationen zu identifizieren, die möglicherweise nicht konform sind, ohne dass andere Untermessungsgeräte verwendet werden.

2. Verfahren nach Anspruch 1, ferner umfassend:
Abrufen von Wetterdaten (312) aus einer Wetterdatenbank; und
Bestätigen oder Verneinen, dass die identifizierten elektrischen Installationen wahrscheinlich eine NCE aufweisen, indem man die Wetterdaten mit den NCE-Indikatoren, die ihre Zielbedingungen erfüllt haben, abgleicht,
Wobei die Wetterdaten mindestens eine der folgenden Informationen umfassen: eine lokale Außentemperatur; ein Datum; eine Uhrzeit, die zu dem Zeitpunkt bestimmt wurde, als die Profile generiert wurden.

3. Verfahren nach einem der vorherigen Ansprüche 2, ferner umfassend:
die Art der elektrischen Installationen als einphasig oder mehrphasig identifizieren, basierend auf den abgerufenen Profilen und/oder auf nominativen Informationen,
elektrische Profile aus einphasigen und zweiphasigen Installationen, die zumindest Spannungs- (in V) und Wirkenergieprofile (in kWh) umfassen; und
die wiedergewonnenen Profile aus mehrphasigen elektrischen Installationen, die die gesamte Wirkenergie (in kWh) und pro elektrischer Phase (φ_{A}, φ_{B}, φ_{C}) umfassen, eine Messung der gesamten scheinbaren Energie (in kVAh) und pro elektrischer Phase, eine Messung der Blindenergie (kVARh) insgesamt und pro elektrischer Phase, eine Messung der Spannungen (in V) pro Phase und eine Messung der Ströme (in A) pro Phase.

4. Verfahren nach einem der Ansprüche 1 bis 3, wobei:
ein Teil der NCE-Indikatoren autonome Indikatoren sind, d. h. solche, bei deren algorithmischer Verarbeitung nur die Daten aus den Profilen der analysierten Installation verwendet werden, und
ein Teil der NCE-Indikatoren relationale Indikatoren sind, d.h. solche, die die Profile benachbarter Installationen einbeziehen, d.h. die mit demselben Verteilungstransformator, derselben elektrischen Phase, derselben Stromleitung oder derselben Verteilerstation verbunden sind.

5. Verfahren nach einem der Ansprüche 1 bis 4, wobei in Schritt d) ein Teil der algorithmischen Verarbeitungen mit einer ersten Klasse von NCE-Indikatoren, die als Positionsindikatoren (420) bezeichnet werden, verknüpft wird, wobei das Verfahren eine Aktion zum Berechnen mindestens eines Positionsindikators und zum Bestimmen umfasst, ob:
- eine bestimmte elektrische Installation an einer analysierten Stromleitung liegt, aber an einen anderen als den in den nominativen Daten definierten Transformator angeschlossen ist; oder
- eine bestimmte Installation nicht an die analysierte Stromleitung angeschlossen ist;
wobei das Verfahren weiterhin einen Schritt umfasst, bei dem anhand der berechneten indikativen Positionsdaten eine Wahrscheinlichkeit validiert wird, dass die in Schritt e) identifizierten elektrischen Installationen nicht konforme Installationen sind.

6. Verfahren nach einem der Ansprüche 1 bis 5, wobei in Schritt d) ein Teil der algorithmischen Verarbeitungen einer zweiten Klasse von NCE-Indikatoren zugeordnet wird, die als Zustandsindikatoren (430, 460) bezeichnet werden, wobei das Verfahren eine Aktion zum Berechnen von mindestens einem der folgenden Zustandsindikatoren umfasst:
- Erfassungsrate von Energiedaten;
- Erfassungsrate der Spannungsdaten;
- Debalancing in Spannung;
- Debalancing in Strom;
- Verhältnis von scheinbarer Energie und Wirkenergie;
wobei das Verfahren weiterhin einen Schritt umfasst, in dem anhand der berechneten indikativen Zustandsdaten eine Wahrscheinlichkeit validiert wird, dass die in Schritt e) identifizierten elektrischen Installationen nicht konforme Installationen sind.

7. Verfahren nach einem der Ansprüche 1 bis 6, wobei in Schritt d) ein Teil der algorithmischen Verarbeitungen mit der ersten Unterklasse von nicht-technischen Verlustindikatoren (440, 470) verknüpft wird, wobei das Verfahren eine Aktion zum Berechnen von mindestens einem Indikator einer Zählermanipulation oder eines fehlerhaften Zählers (441, 471) aus Folgendem umfasst:
- Veränderung der Spannungsspule;
- identische Daten in Energie;
- identische Daten in Spannung;
- Vorwiderstand auf Stromtransformator; und
- dreiphasiger Nullstrom mit Verbrauch ungleich Null;
wobei das Verfahren weiterhin einen Schritt umfasst, in dem anhand der berechneten indikativen Daten für nicht-technische Verluste eine Wahrscheinlichkeit validiert wird, dass die in Schritt e) identifizierten elektrischen Installationen nicht konforme Installationen sind.

8. Verfahren nach einem der Ansprüche 1 bis 7, wobei in Schritt d) ein Teil der algorithmischen Verarbeitungen mit einer zweiten Unterklasse von nicht-technischen Verlustindikatoren verbunden ist, wobei das Verfahren eine Aktion zum Berechnen von mindestens einem Anomalieindikator durch Vergleich (442, 472) umfasst aus:
- Nachtkonsum;
- Spannungsabweichung der einphasigen Mittelwerte;
- Spannungsabweichung der Zwischenphasenmittelwerte;
- Spannungsabweichung der Inter-Client-Mittelwerte;
- Spannungsabweichung der Mittelwerte unter einem Mehrphasentransformator;
- Spannungsniveau bei Nullverbrauch;
- Stromverhältnis;
- nicht synchronisierter Spannungsverlust und -wiederkehr; und
wobei das Verfahren weiterhin einen Schritt umfasst, bei dem anhand der indikativen Daten, die auf Anomalien hinweisen, durch Vergleich eine Wahrscheinlichkeit validiert wird, dass die in Schritt e) identifizierten elektrischen Installationen nicht konforme Installationen sind.

9. Verfahren nach einem der Ansprüche 1 bis 8, wobei in Schritt d) ein Teil der algorithmischen Verarbeitungen mit einer dritten Unterklasse von nicht-technischen Verlustindikatoren verknüpft wird, wobei das Verfahren eine Aktion zum Berechnen mindestens eines Indikators für ungeeignete Zähleranschlüsse oder Komponenten (443, 473) umfasst, aus:
- Abwesenheit von Strom;
- Abwesenheit von Spannung;
- negative Energiedaten;
- Nullspannung mit Strom;
wobei das Verfahren weiterhin einen Schritt umfasst, in dem anhand der indikativen Daten eines Zähleranschlusses oder seiner ungeeigneten Komponenten eine Wahrscheinlichkeit validiert wird, dass die in Schritt e) identifizierten elektrischen Installationen nicht konforme Installationen sind.

10. Verfahren nach einem der Ansprüche 1 bis 9, wobei in Schritt d) ein Teil der algorithmischen Verarbeitungen mit einer vierten Unterklasse von nicht-technischen Verlustindikatoren verbunden ist, wobei das Verfahren eine Aktion zur Berechnung eines Indikators für transiente Aberrationen (444, 474) durch die Identifizierung großer Spannungsabweichungen auf den Profilen umfasst,
wobei das Verfahren weiterhin einen Schritt umfasst, bei dem anhand der indikativen Daten für transiente Aberrationen eine Wahrscheinlichkeit validiert wird, dass die in Schritt e) identifizierten elektrischen Installationen nicht konforme Installationen sind.

11. Verfahren nach einem der Ansprüche 1 bis 10, wobei in Schritt d) ein Teil der algorithmischen Verarbeitungen mit einer fünften Unterklasse von nicht-technischen Verlustindikatoren verbunden ist, wobei das Verfahren eine Aktion zum Berechnen von mindestens einem Indikator (445, 475) für eine Betriebsart außerhalb der Norm umfasst, aus:
- Bi-Energie-Heizungsindikator;
- außergewöhnliche Spitzenleistung;
- durchschnittliche Spannung außerhalb der Norm;
- Transformator mit nur einem Anschluss;
- disparater Bestimmungsfaktor;
- Validierung der verbrauchten Wirkenergie;
- aus der Norm fallende Spannung mit Strom;
wobei das Verfahren außerdem einen Schritt umfasst, bei dem anhand der indikativen Daten für den nicht normgerechten Betriebsmodus eine Wahrscheinlichkeit validiert wird, dass es sich bei den in Schritt e) identifizierten elektrischen Installationen um nicht konforme Installationen handelt.

12. Verfahren nach einem der Ansprüche 1 bis 11, wobei in Schritt d) ein Teil der algorithmischen Verarbeitung einer sechsten Unterklasse von Indikatoren für nicht-technische Verluste zugeordnet wird, wobei das Verfahren eine Aktion zum Berechnen von mindestens einem Indikator für die Erkennung von nicht-konformen zyklischen elektrischen Lasten (446, 476) umfasst, unter:
- Fourier-Transformation, die auf Spannungs- und Energiemessungen für bestimmte Zeiträume (Zyklen) angewendet wird;
- Vorhandensein von zyklischer Spannung ohne Leistungsabruf;
wobei das Verfahren ferner einen Schritt umfasst, bei dem anhand der indikativen Daten für nicht konforme zyklische Belastungen eine Wahrscheinlichkeit validiert wird, dass die in Schritt e) identifizierten elektrischen Installationen nicht konforme Installationen sind.

13. Das Verfahren nach einem der Ansprüche 1 bis 12, das einen Schritt zum Erzeugen von Grafiken (340) umfasst, die visuell die NCE-Indikatoren darstellen, die die Zielbedingungen erfüllt haben.

14. Das Verfahren nach einem der Ansprüche 1 bis 13 das einen Schritt umfasst, bei dem über eine Softwareanwendung Inspektionsanfragen (350) für elektrische Installationen erzeugt werden, die als potenziell NCE-verdächtig identifiziert wurden.

15. Das Verfahren nach einem der Ansprüche 1 bis 14, das einen Schritt des Priorisierens von elektrischen Installationen umfasst, die als potenziell NCE-verdächtig identifiziert wurden, auf der Grundlage eines Grads der Gewissheit, dass eine bestimmte Installation NCE aufweist, wobei der Grad an Gewissheit mit der Anzahl, dem Auftreten und dem Typ von NCE-Indikatoren zusammenhängt, die die Zielbedingungen erfüllt haben.

16. Verfahren nach einem der Ansprüche 1 bis 15, wobei die Messungen, die die elektrischen Profile bilden, von den Zählern mindestens einmal pro Stunde vorgenommen und von den Zählern an das Datenverwaltungssystem weitergeleitet werden.

17. Das Verfahren nach einem der Ansprüche 1 bis 16, das einen Schritt zum automatischen Unterbrechen der Stromversorgung (260) für mindestens einige der in Schritt e) identifizierten elektrischen Installationen umfasst, Schritt des Unterbrechens der Stromzufuhr, der das Senden einer Anforderung zum Öffnen eines Steuerelements umfasst, das sich in dem Zähler befindet, der mit der als nicht konform bestimmten elektrischen Installation verbunden ist.

18. Ein System zur automatischen Identifizierung von elektrischen Installationen, die wahrscheinlich eine elektrische Nichtkonformität (NCE) in einem elektrischen Verteilungsnetz (100) aufweisen, wobei das System ein Datenverwaltungssystem, Zähler (120), die von den Energieversorgungsunternehmen zu Abrechnungszwecken auf der Grundlage von Messungen, die von den Zählern vorgenommen werden, eingesetzt werden umfasst, und mindestens eine algorithmische Verarbeitungseinheit (180) mit einem Prozessor und einem Speicher, der mit dem Prozessor in Verbindung steht, wobei der Speicher Befehle enthält, die von dem Prozessor ausgeführt werden können, um Folgendes zu tun:
a) Abrufen von elektrischen Profilen (310), die mit den elektrischen Installationen (110, 112) verbunden sind, aus dem Datenverwaltungssystem, wobei die Profile von den Zählern (120) erzeugt werden und die Profile zeitlich gestaffelt sind;
wobei das System **dadurch gekennzeichnet ist, dass** der Speicher durch den Prozessor ausführbare Anweisungen umfasst, um Folgendes zu tun:
b) Abrufen von nominativen Daten (111), die die elektrischen Installationen charakterisieren, aus einer Datenbank (182), wobei die nominativen Daten für jede der elektrischen Installationen mindestens eines der Folgenden enthalten:
- Art der elektrischen Installation: einphasig oder mehrphasig;
- Tarif, dem die elektrische Installation unterliegt;
- Zweckbestimmung des Gebäudes/der Gebäude, das/die mit der elektrischen Installation verbunden ist/sind, wobei es sich um eine Wohnnutzung, eine gewerbliche Nutzung, eine institutionelle Nutzung oder eine industrielle Nutzung handeln kann; und
- Hauptenergiequelle, die zum Beheizen des Gebäudes bzw. der Gebäude verwendet wird,
c) Auswahl eines Teils der auf die Profile anzuwendenden NCE-Indikatoren auf der Grundlage der in den nominativen Daten enthaltenen Informationen aus nicht-technischen Positions-, Zustands- oder Verlustindikatoren;
d) Anwenden von algorithmischen Verarbeitungen, die mit den ausgewählten NCE-Indikatoren verbunden sind, in Abhängigkeit von Zielbedingungen auf die in Schritt a) abgerufenen elektrischen Profile, um indikative Daten zu erhalten, die auf verschiedene Arten von NCE hindeuten;
e) anhand der in Schritt d) erhaltenen Daten die besagten elektrischen Installationen zu identifizieren, die möglicherweise eine NCE aufweisen, wenn die Zielbedingungen erfüllt sind;
f) zu bestätigen oder zu verneinen, dass die identifizierten elektrischen Installationen wahrscheinlich eine NCE aufweisen, indem man diese personenbezogenen Informationen mit den NCE-Indikatoren, die ihre Zielbedingungen erfüllt haben, abgleicht; und
g) Generieren einer Ergebnisstruktur (330), die indikative Daten für die verschiedenen Arten von potenziellen NCE enthält, die für jede bestätigte elektrische Installation identifiziert wurden,
wobei das System nur die von den Zählern erzeugten Profile und die mindestens eine algorithmische Verarbeitungseinheit benötigt, um elektrische Installationen zu identifizieren, die möglicherweise nicht konform sind, ohne auf andere Untermessungsgeräte zurückzugreifen.

19. Das System nach Anspruch 18, das eine oder mehrere Datenbanken umfasst (172, 182), um Folgendes zu speichern: die von den Zählern erzeugten elektrischen Profile; und eindeutige Identifikatoren, die mit den elektrischen Installationen im Netz verbunden sind, die wahrscheinlich eine NCE aufweisen.

20. Das System nach Anspruch 19, das mindestens einen Bildschirm umfasst, der direkt oder indirekt mit der mindestens einen Verarbeitungseinheit verbunden ist, wobei der Speicher vom Prozessor ausführbare Anweisungen umfasst, um auf dem Bildschirm eine Benutzeroberfläche anzuzeigen, die es ermöglicht, NCE-Indikatoren auszuwählen, die auf die elektrischen Profile anzuwenden sind, die Gesamtheit oder einen Teil der Profile auszuwählen, auf die die mit den ausgewählten Indikatoren verbundenen algorithmischen Verarbeitungen angewendet werden sollen, und die eindeutigen Kennungen der elektrischen Installationen anzuzeigen, die als wahrscheinlich nicht konform identifiziert wurden.

21. Das System nach Anspruch 20, das Mittel zum Senden einer Anfrage zum Öffnen eines Steuerelements umfasst, das sich in dem Zähler befindet, der mit der als nicht konform ermittelten elektrischen Installation verbunden ist.

## Claims

1. A method of automatically detecting electrical installations likely to exhibit an electrical non-conformity (ENC) on an electrical distribution system (100), the electrical installations (110, 112) being connected to meters (120), the method comprising the steps of:
a) retrieving (200), from a meter data management system (170), electrical profiles associated with the electrical installations, the profiles being generated by said meters deployed by electrical utilities for billing purposes, the profiles being spread over time;
the method being **characterized in that** it comprises the steps of:
b) recovering nominative data (311) characterizing the electrical installations from a database (182), the nominative data comprising, for each of the electrical installations, at least one of :
- whether the electrical installation is single-phase or polyphase;
- tariffs to which the electrical installation is subject;
- vocation of the building(s) associated with the electrical installation, among residential, commercial, institutional or industrial; and
- main source of energy used to heat the building(s),
c) selecting (210) at least some of the NCE indicators to be applied to the profiles according to the information contained in the nominative data, from among non-technical positioning indicators, state indicators or non-technical loss indicators;
d) applying, using IT tools, algorithmic processing associated with the selected NCE indicators, according to target conditions, to the electrical profiles recovered in step a), to obtain data indicative of different types of NCE;
e) identify, from the data obtained in step d), said electrical installations likely to exhibit NCE, when the target conditions are met;
f) confirming or denying that the identified electrical installations are indeed likely to present an NCE, by cross-referencing said nominative information with the NCE indicators that have met their target conditions; and
g) generating a results structure (330) comprising the data indicative of the different types of potential NCE identified for each confirmed electrical installation,
said method requiring only the electrical profiles generated by the meters and IT tools to identify electrical installations likely to be non-compliant, without recourse to any other sub-metering equipment.

2. The method according to claim 1, further comprising:
retrieving meteorological data (312) from a meteorological database; and
confirming or denying that the identified electrical installations are likely to present an NCE, by cross-referencing said meteorological data with the NCE indicators that have met their target conditions,
the meteorological data comprising at least one of the following items of information: a local outside temperature; a date; a time when the profiles were generated.

3. The method according to claim 1 or 2, further comprising:
identifying whether the electrical installations are single-phase or polyphase based on the retrieved profiles and/or the nominative information,
the electrical profiles from the single-phase and two-phase installations comprising at least voltage (in V) and active energy (in kWh) profiles; and
the profiles recovered from the polyphase electrical installations, comprising active energy total (in kWh) and per electrical phase (ϕA, ϕB, ϕC), apparent energy measurement total (in kVAh) and per electrical phase, reactive energy measurement total (kVARh) and per electrical phase, voltage measurement (in V) per phase and current measurement (in A) per phase.

4. The method according to any one of claims 1 to 3, wherein:
a part of the NCE indicators are autonomous or standalone indicators, the autonomous or standalone indicators corresponding to indicators whose algorithmic processing involves only data from the profiles of the installation being analyzed, and
a part of the NCE indicators are relational indicators, the relational indicators corresponding to indicators involving the profiles of neighboring installations, i.e. installations connected to the same distribution transformer, the same electrical phase, the same electrical line or the same distribution substation.

5. The method according to any one of claims 1 to 4, wherein in step d) some of the algorithmic processing is associated with a first class of NCE indicators called positioning indicators (420), the method comprising calculating at least one positioning indicator, and determining whether :
- a given electrical installation is located on an analyzed power line, but is connected to a transformer other than the one defined in the nominative data; or
- a given installation is not connected to the analyzed power line;
the method further comprising a step of validating, on the basis of the position indicator data calculated, a probability that the electrical installations identified in step e) are non-compliant installations.

6. The method according to any one of claims 1 to 5, wherein in step d), some of the algorithmic processing is associated with a second class of NCE indicators called state indicators (430, 460), the method comprising calculating at least one of the following state indicators:
- energy data capture rate;
- voltage data capture rate;
- voltage unbalancing;
- current unbalancing;
- apparent and active energy ratio;
the method further comprising a step of validating, from the data indicative of the electrical installation state, a probability that the electrical installations identified in step e) are non-compliant installations.

7. The method according to any one of claims 1 to 6, wherein in step d) some of the algorithmic processing is associated with a first subclass of non-technical loss indicators (440, 470), the method comprising calculating at least one indicator of a meter manipulation or faulty meter (441, 471) from :
- an alteration of the voltage winding or coil ;
- identical energy data;
- identical voltage data;
- a resistance in series on current transformer; and
- zero three-phase current with non-zero consumption;
the method further comprising a step of validating, on the basis of the calculated indicative non-technical loss data, a probability that the electrical installations identified in step e) are non-compliant installations.

8. The method according to any one of claims 1 to 7, wherein in step d) some of the algorithmic processing is associated with a second subclass of non-technical loss indicators, the method comprising calculating at least one anomaly indicator by comparison (442, 472) among:
- night-time consumption ;
- voltage deviation of single-phase mean values ;
- voltage deviation of interphase mean values;
- voltage deviation of inter-customer mean values;
- voltage deviation of average values under a polyphase transformer;
- voltage level at zero consumption ;
- current ratio ;
- unsynchronized voltage loss and return; and
the method further comprising a step of validating, from the data indicative of anomalies by comparison, a probability that the electrical installations identified in step e) are non-compliant installations.

9. The method according to any one of claims 1 to 8, wherein in step d) some of the algorithmic processing is associated with a third subclass of non-technical loss indicators, the method comprising calculating at least one inadequate meter or component connection indicator (443, 473) from :
- absence of current ;
- no voltage ;
- negative energy data ;
- zero voltage with current;
the method further comprising a step of validating, from the data indicative of an inadequate meter connection or components, a probability that the electrical installations identified in step e) are non-compliant installations.

10. The method according to any one of claims 1 to 9, wherein in step d) some of the algorithmic processing is associated with a fourth subclass of non-technical loss indicators, the method comprising calculating a transient aberration indicator (444, 474) by identifying large voltage deviations on said profiles,
the method further comprising a step of validating, from the transient aberration indicator data, a probability that the electrical installations identified in step e) are non-compliant installations.

11. The method according to any one of claims 1 to 10, wherein in step d) some of the algorithmic processing is associated with a fifth subclass of non-technical loss indicators, the method comprising an action of calculating at least one non-standard mode of operation indicator (445, 475) from :
- dual-energy heating indicator ;
- non-standard peak power ;
- non-standard mean voltage ;
- single-connection transformer;
- disparate determination factor;
- validation of active energy consumed ;
- non-standard voltage with current;
the method further comprising a step of validating, on the basis of the data indicative of non-standard mode of operation, a probability that the electrical installations identified in step e) are non-compliant installations.

12. The method according to any one of claims 1 to 11, wherein in step d) some of the algorithmic processing is associated with a sixth subclass of non-technical loss indicators, the method comprising calculating at least one non-compliant cyclic electrical load detection indicator (446, 476) from :
- A Fourier transform applied to voltage and energy measurements for given periods (cycles);
- presence of cyclic voltage without power draw;
the method further comprising a step of validating, from the data indicative non-compliant cyclic electrical loads, a probability that the electrical installations identified in step e) are non-compliant installations.

13. The method according to any one of claims 1 to 12, comprising a step of generating graphs (340) visually representing the NCE indicators having met their target conditions.

14. The method according to any one of claims 1 to 13, comprising a step of generating, via a software application, inspection requests (350) for electrical installations identified as likely to present an NCE.

15. The method according to any one of claims 1 to 14, comprising a step of assigning priority to electrical installations identified as likely to present an NCE, according to a degree of certainty as to the existence of an NCE for a given installation, the degree of certainty being related to the number, occurrence, and type of NCE indicators having met their target conditions.

16. The method according to any one of claims 1 to 15, wherein the measurements constituting the electrical profiles are taken by the meters at least once an hour and are routed by the meters to the meter data management system.

17. The method according to any one of claims 1 to 16, comprising a step of automatically interrupting the electricity supply (260) for at least some of the electrical installations identified in step e), the step of interrupting the electricity supply involves sending a request to open a control element located in the meter linked to the electrical installation determined to be non-compliant.

18. A system for automatically identifying electrical installations likely to present an electrical non-conformity (NCE) on an electrical distribution network (100), the system comprising at least one algorithmic processing unit (180) having a processor and a memory in communication with the processor, the memory comprising instructions executable by the processor for:
a) retrieving, from a data management system (170), electrical profiles (310) associated with electrical installations (110, 112), the profiles being generated by meters (120) deployed by electrical utilities for billing purposes from measurements taken by said meters, the profiles being spread over time;
the system being **characterized in that** the memory includes instructions for:
b) recovering nominative data (311) characterizing the electrical installations from a database (182), the nominative data comprising, for each of the electrical installations, at least one of :
- whether the electrical installation is single-phase or polyphase;
- tariff to which the electrical installation is subject;
- vocation of the building(s) associated with the electrical installation, among residential, commercial, institutional or industrial; and
- main source of energy used to heat the building(s),
c) selecting (210) at least some of the NCE indicators to be applied to the profiles according to the information contained in the nominative data, from among non-technical positioning indicators, state indicators or non-technical loss indicators;
d) applying, using IT tools, algorithmic processing associated with the selected NCE indicators, according to target conditions, to the electrical profiles recovered in step a), to obtain data indicative of different types of NCE;
e) identify, from the data obtained in step d), said electrical installations likely to exhibit NCE, when their target conditions are met;
f) confirming or denying that the identified electrical installations are indeed likely to present an NCE, by cross-referencing said nominative information with the NCE indicators that have met their target conditions; and
g) generating a results structure (330) comprising the data indicative of the different types of potential NCE identified for each confirmed electrical installation,
said method requiring only the electrical profiles generated by the meters and IT tools to identify electrical installations likely to be non-compliant, without recourse to any other sub-metering equipment.

19. The system according to claim 18, comprising one or more databases (172, 182) for storing: the calculated NCE indicators; the electrical profiles generated by the meters; and unique identifiers associated with electrical installations in the network which are likely to exhibit NCE.

20. The system according to claim 19, comprising at least one display screen connected directly or indirectly to the at least one processing unit(s), the memory comprising instructions executable by the processor to display on the display screen a user interface enabling selection of NCE indicators to be applied to the electrical profiles, selection of all or some of the profiles to which the algorithmic treatments associated with the selected indicators are to be applied and display of the unique identifiers of the electrical installations identified as likely to be non-compliant.

21. The system according to claim 20, comprising means for sending a request to open a control element located in the meter related to the electrical installation determined to be non-compliant.
